# EUROPEAN PATENT APPLICATION

(11) **EP 4 671 411 A1**
(43) Date of publication of application: **31.12.2025**
(21) Application number: 23936478.9
(22) Date of filing: 18.12.2023
(51) Int. Cl.: C23C 16/505, C23C 16/44, C23C 16/52

(54) **RADIO FREQUENCY FEED STRUCTURE AND PECVD DEVICE HAVING SAME**

(30) Priority: 06.05.2023 CN 202321064841 U
(71) Applicant: Suzhou Maxwell Technologies Co., Ltd., Suzhou, Jiangsu 215200 (CN); Suzhou Maizheng Technology Co., Ltd, Suzhou, Jiangsu 215200 (CN)
(72) Inventor: QU, Qingyuan, Suzhou, Jiangsu 215200 (CN); WANG, Fengming, Suzhou, Jiangsu 215200 (CN); GAO, Lei, Suzhou, Jiangsu 215200 (CN); ZHANG, Heng, Suzhou, Jiangsu 215200 (CN); HAN, Shaowen, Suzhou, Jiangsu 215200 (CN)
(74) Representative: Balder IP Law, S.L.
(86) International application number: PCT/CN2023/139496
(87) International publication number: WO 2024/230174

(57) **Abstract**

This application discloses a radio frequency feeding structure and a PECVD apparatus with the same, which belongs to the field of chemical vapor deposition. A radio frequency feeding structure is used for a PECVD apparatus. The radio frequency feeding structure includes: at least one first connecting member, the first end of the first connecting member is connected to a radio frequency power supply system; a fixing plate, the fixing plate is provided with a fixing hole, the fixing hole extends in a first direction, and the second end of the first connecting member is connected to the fixing hole; a plurality of second connecting members, the first end of each second connecting member is connected to the fixing hole, and the first end of the second connecting member is adapted to move in the first direction along the fixing hole, and the second end of the second connecting member is used for electrically connecting to an electrode in the reaction chamber of the PECVD apparatus. This application can realize a multi-point feeding mode, which helps to improve the uniformity of the electric potential distribution, and can alleviate the problems of inconvenient installation, disassembly and adjustment of the current multi-point fixed feeding mode.

## Description

### TECHNICAL FIELD

The application belongs to the technical field of chemical vapor deposition, and specifically relates to a radio frequency feeding structure and a PECVD apparatus with the same.

### BACKGROUND

Plasma-Enhanced Chemical Vapor Deposition (PECVD) is widely applied in the production of solar cells, semiconductor manufacturing and so on. PECVD apparatus adopts a radio frequency plasma source, which has the characteristics of high frequency and low plasma bombardment. The use of a radio frequency plasma source can reduce the bombardment of plasma on the substrate (such as a silicon wafer) of a solar cell, and improve the quality of the solar cell.

In order to meet the requirements for the film quality and production capacity of solar cells on the production line, the film preparation process usually employs high-frequency and very-high-frequency power supplies, and the output power of the power supplies is also relatively large. Increasing the frequency of plasma glow discharge is helpful for improving the quality and deposition rate of microcrystalline silicon films. However, as the frequency of the power supply increases, various electromagnetic effects such as the standing wave effect, skin effect, logarithmic singularity effect, and electrostatic edge effect will affect the uniformity of the plasma potential, thereby affecting the uniformity of plasma film deposition. The radio frequency power supply can transmit radio frequency signal to the electrode plate through the radio frequency feeding structure. Designing a reasonable radio frequency feeding structure and feeding mode is conducive to improving the film uniformity, deposition rate, apparatus stability and installation operability.

In the related art, in large-scale parallel-plate capacitively coupled plasma film deposition apparatus, the single-point feeding mode is often used for the feeding structure. However, the single-point feeding mode is relatively simple and it is difficult to improve the poor potential uniformity caused by various electromagnetic effects, which affects the uniformity of plasma film deposition. In addition, there are also some feeding structures using the multi-point feeding mode. However, most of the existing multi-point feeding modes are multi-point fixed feeding modes. This multi-point feeding mode is cumbersome and inconvenient in terms of movement and installation, and it is difficult to optimize and adjust in a timely manner according to the experimental results.

### SUMMARY

The application aims to solve at least one of the technical problems in the above related technologies to a certain extent. Therefore, the purpose of this application is to provide a radio frequency feeding structure and a PECVD apparatus with the same, which can realize the multi-point feeding mode, help improve the uniformity of electric potential distribution, and alleviate the inconveniences in installation, disassembly and adjustment of the current multi-point fixed feeding mode.

To solve the above technical problems, this application is implemented as follows:
According to one aspect of this application, an embodiment of this application provides a radio frequency feeding structure for a PECVD apparatus. The radio frequency feeding structure includes:
At least one first connecting member, the first end of which is connected to the radio frequency power supply system;
A fixing plate, which is provided with a fixing hole extending in a first direction. The second end of the first connecting member is connected to the fixing hole;
A plurality of second connecting members, the first end of each second connecting member is connected to the fixing hole, and the first end of the second connecting member is suitable for moving along the fixing hole in the first direction. The second end of the second connecting member is used for electrically connecting to an electrode in the reaction chamber of the PECVD apparatus.

In addition, the radio frequency feeding structure according to the present application may also have the following additional technical features:
In one of the embodiments, the radio frequency feeding structure further includes a first fixing component and a second fixing component;
The first fixing component includes a first fixing plate and a first fastener, the first fixing plate is connected to the second end of the first connecting member, and the first fastener is inserted through the first fixing plate, the second end of the first connecting member, and the fixing hole to fix the second end of the first connecting member.

The second fixing component includes a second fixing plate and a second fastener, the second fixing plate is connected to the first end of the second connecting member, and the second fastener is inserted through the second fixing plate, the first end of the second connecting member, and the fixing hole to fix the first end of the second connecting member.

In one of the embodiments, the number of the second connecting members is 2 to 10, so that the radio frequency feeding structure forms a feeding structure with 2 to 10 input points.

In one of the embodiments, the number of the second connecting members is 4 to 8, so that the radio frequency feeding structure forms a feeding structure with 4 to 8 input points.

In one of the embodiments, a plurality of the second connecting members are arranged at intervals, and the distance between the second connecting members is adjustable.

In one of the embodiments, the fixing plate is in the shape of a circular ring or an elliptical ring. The fixing hole is an arc-shaped fixing hole, and the second end of the first connecting member and the first end of the second connecting member are respectively adjustable and movable along the arc-shaped fixing hole.

In one of the embodiments, the fixing plate is in the shape of a square ring, the fixing hole is a linear fixing hole, and the second end of the first connecting member and the first end of the second connecting member are respectively adjustable and movable along the linear fixing hole.

In one of the embodiments, the fixing plate comprises a first main plate and a second main plate, the first main plate and the second main plate are detachably connected together to form the fixing plate.

In one of the embodiments, the first main plate is provided with a first protruding connecting portion, and the second main plate is provided with a second protruding connecting portion, the first protruding connecting portion is butted against the second protruding connecting portion, and fasteners are used to connect the first protruding connecting portion and the second protruding connecting portion together tightly.

In one of the embodiments, the number of the fixing holes is multiple, and the multiple fixing holes are arranged at intervals along the second direction.

In one of the embodiments, the materials of the first connecting member, the second connecting member and the fixing plate are each independently metals or alloys, the metals can be copper, aluminum, gold or silver, and the alloys can be copper-aluminum alloy, copper-silver alloy, copper-nickel alloy or copper-tin alloy.

In one of the embodiments, the materials of the first connecting member, the second connecting member and the fixing plate each independently include composite materials, the composite materials include a base material and a coating layer disposed on the outer surface of the base material, the base material includes copper or aluminum, and the coating layer includes a gold coating layer or a silver coating layer.

In one of the embodiments, the number of the first connecting members is two, the first ends of the two first connecting members are respectively connected to two different radio frequency power supply systems, and the second ends of the two first connecting members are respectively connected to the fixing holes.

In one of the embodiments, both the first end and the second end of the first connecting member are provided with smooth first chamfered portions, and the outer surface of the first connecting member has a polished smooth surface.

In one of the embodiments, both the first end and the second end of the second connecting member are provided with smooth second chamfered portions, and the outer surface of the second connecting member has a polished smooth surface.

In one of the embodiments, the first connecting member is in the shape of a Z; and/or,
The second connecting member is in the shape of a Z.

According to another aspect of the present application, an embodiment of the present application further provides a PECVD apparatus, which includes the radio frequency feeding structure as described above.

### Beneficial effect

Compared with the prior art, the technical solution provided by the present disclosure has the following beneficial effects:
In the embodiment of the present application, the provided radio frequency feeding structure includes a first connecting member, a fixing plate and a plurality of second connecting members. The first end of the first connecting member can be used for electrically connecting with the radio frequency power supply, and the second end of the second connecting member can be used for electrically connecting with an electrode such as a cathode in the reaction chamber of the PECVD apparatus. The second end of the first connecting member and the first end of the second connecting member can be respectively connected to the fixing holes of the fixing plate. Moreover, the number of the second connecting members is multiple, and the positions of the second connecting members can be adjusted by moving along the fixing holes during installation. Thus, through the cooperative arrangement of the first connecting member, the fixing plate and the multiple second connecting members, and allowing the second connecting members to move on the fixing holes. It can not only realize the multi-point feeding mode, but also improve the uniformity of the electric potential distribution by changing the number and positions of the power feeding points. Reasonably arranging the positions and the number of feeding points helps to mitigate various electromagnetic effects such as the logarithmic singularity effect, electrostatic edge effect, electric potential standing wave effect and skin effect near the feeding points, thereby improving the uniformity of very-high-frequency film deposition. This feeding structure has good apparatus compatibility, and is convenient and quick for installation and disassembly. It can be adjusted promptly and accurately according to different apparatus working conditions and experimental results, thus facilitating installation, disassembly and adjustment, helping to summarize the regularities, and improving the film deposition uniformity.

The additional aspects and advantages of the present application will be partly provided in the following description, and partly will become apparent from the following description, or can be learned through the practice of the present utility model.

### BRIEF DESCRIPTION OF THE DRAWING

Figure 1 is a structural schematic diagram of the radio frequency feeding structure disclosed in one embodiment of the present application;
Figure 2 is a structural schematic diagram of the radio frequency feeding structure disclosed in other embodiment of the present application.

### Description of elements in the drawings:

100: first connecting member;
110: first end of the first connecting member;
120: second end of the first connecting member;
200: second connecting member;
210: first end of the second connecting member;
220: second end of the second connecting member;
300: fixing plate;
301: fixing hole;
310: first main plate;
320: second main plate;
400: first fixing component;
410: first fixing plate;
420: first fastener;
500: second fixing component;
510: second fixing plate;
520: second fastener.

### DETAILED DESCRIPTION OF THE EMBODIMENTS

The following will clearly and completely describe the technical solutions in the embodiments of the present application with reference to the accompanying drawings in the embodiments of the present application. Obviously, the described embodiments are part of the embodiments of the present application, not all of them. Based on the embodiments in the present application, all other embodiments obtained by a person of ordinary skill in the art without making creative efforts fall within the scope of protection of the present application.

The following will describe in detail the embodiments of the present application through specific embodiments and their application scenarios with reference to the accompanying drawings.

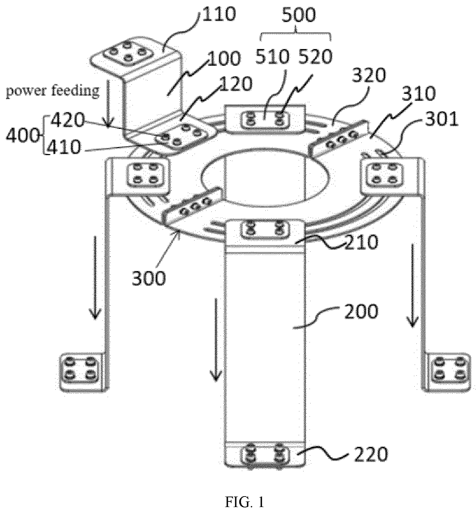

Referring to Figure 1, in some embodiments of the present application, a radio frequency feeding structure is provided, which can be applied to a PECVD apparatus. The radio frequency power supply of the PECVD apparatus can transmit radio frequency signals to the electrodes in the PECVD reaction chamber through the radio frequency feeding structure. The radio frequency feeding structure of this embodiment can implement a multi-point feeding mode. By setting a reasonable radio frequency feeding structure and multi-point feeding mode, it helps to improve the uniformity of radio frequency film deposition, increase the deposition rate, and also improve the apparatus stability and installation operability.

Specifically, the radio frequency feeding structure includes: at least one first connecting member 100, a plurality of second connecting members 200, and a fixing plate 300. The first connecting member 100 is the main feeding connection path, which can be used to connect to the radio frequency power supply system. For example, the radio frequency power supply system can adopt a series of combinations including a radio frequency power supply, a matching circuit, etc. The first connecting member 100 is connected to the radio frequency power supply and is matched with the corresponding matching circuit. The second connecting member 200 is the secondary feeding connection path, which can be used to connect to the electrodes in the PECVD reaction chamber. The fixing plate 300 can be used to install the first connecting member 100 and the second connecting member 200.

The fixing plate 300 is provided with a fixing hole 301, which extends in a first direction. The fixing hole 301 is the installation port for the main feeding connection path and the secondary feeding connection path. The fixing hole 301 can be a through hole or a blind hole, preferably a through hole. According to the different shapes and structures of the fixing plate 300, the extension direction of the fixing hole 301 can be adjusted adaptively. For example, when a circular fixing plate is used, the fixing hole 301 can extends in the circumferential direction of the circular fixing plate. Or, when a square fixing plate is used, the fixing hole 301 can extends in the length or width direction of the square fixing plate. When a circular fixing plate 300 is used, the fixing hole 301 can be designed as an arc-shaped fixing hole, and the extension direction of the fixing hole 301, that is, the first direction mentioned above, can be the circumferential direction of the fixing plate 300. When a square-ring-shaped fixing plate 300 is used, the fixing hole 301 can be designed as a linear (such as a straight-line) fixing hole, and the extension direction of the fixing hole 301, that is, the first direction mentioned above, can be the length or width direction of the fixing plate 300.

In this embodiment, part of the fixing hole 301 can be used to fix the first connecting member 100 and the second connecting member 200 by making the fixing hole 301 extends in the first direction, that is, to install the main feeding connection path and the secondary feeding connection path. The remaining part of the fixing hole 301 can also be used for heat dissipation. Therefore, the fixing hole 301 on the fixing plate 300 can not only provide an installation position but also have a heat dissipation function, which helps to dissipate the heat of the radio frequency feeding structure.

The number of the first connecting members 100 mentioned above can be one or more. The first connecting member 100 mentioned above has a first end and a second end. The first end 110 of the first connecting member can be used to connect to a radio frequency power supply system (not shown in the figure 1). The second end 120 of the first connecting member is connected to the fixing hole 301 of the fixing plate 300. Optionally, during installation, the second end 120 of the first connecting member can move along the fixing hole 301 in the first direction. For example, the position of the first connecting member 100 can be adjusted and moved according to the actual distribution of the film deposition to adapt to different actual working conditions or experimental results. At the same time, it also facilitates the adjustment of the position of the second connecting member 200. The installation is convenient and fast, which is conducive to regularity summarization, apparatus development and optimization.

The number of the second connecting members 200 mentioned above is multiple, that is, the number of the second connecting members 200 is at least two. By setting multiple second connecting members 200, a multi-point feeding mode can be formed. The second connecting member 200 has a first end and a second end. The first ends 210 of the multiple second connecting members are respectively connected to the fixing holes 301 of the fixing plate 300, and the first ends 210 of each second connecting member can move along the fixing holes 301 in the first direction during installation. The second ends 220 of the multiple second connecting members can be used for electrically connecting to electrodes such as the cathode (not shown in the figure 1) in the reaction chamber of the PECVD apparatus. In this embodiment, the positions of the first connecting member 100 and the second connecting member 200 are adjustable. For example, during installation, both the first connecting member 100 and the second connecting member 200 can be moved and adjusted along the fixing holes 301 of the fixing plate 300 to adjust the actual installation positions of the first connecting member 100 and the second connecting member 200, especially each second connecting member 200. Furthermore, the positions of the power feeding points can be adjusted according to the actual working conditions or experimental results.

Therefore, based on the above settings, with the radio frequency feeding structure provided in this embodiment, through the coordinated arrangement of the first connecting member 100, the fixing plate 300, and multiple second connecting members 200, the number of the multiple second connecting members 200 can be adjusted according to the actual situation. And the second connecting members 200 can be moved and adjusted along the fixing holes 301 during installation, that is, the installation positions of the second connecting members 200 can be adjusted. It can not only realize the multi-point feeding mode, but also improves the uniformity of the electric potential distribution by changing the number and positions of the power feeding points. Reasonably arranging the positions and the number of feeding points helps to mitigate various electromagnetic effects such as the logarithmic singularity effect, electrostatic edge effect, electric potential standing wave effect, and skin effect near the feeding points, thereby enhancing the uniformity of very-high-frequency film deposition.

The radio frequency feeding structure has good apparatus compatibility, and it is convenient and quick to install and disassemble. It can be adjusted promptly and accurately according to different apparatus working conditions and experimental results, which facilitates installation, disassembly and adjustment, helps to summarize regularities and improve the film deposition uniformity. In addition, after the structure of the apparatus is finalized, the integral casting method can also be used to further reduce the contact influence at the joints.

The size of this radio frequency feeding structure can be adjusted according to different apparatus. While adjusting the size, the system impedance can also be changed, thus achieving better impedance matching with the power supply system.

In one embodiments, the number of the second connecting members 200 is 2 to 10, so that the radio frequency feeding structure forms a feeding structure with 2 to 10 input points. In one embodiments, the number of the second connecting members 200 is 3 to 8, so that the radio frequency feeding structure forms a feeding structure with 3 to 8 input points. In one embodiments, the number of the second connecting members 200 is 4 to 6, so that the radio frequency feeding structure forms a feeding structure with 4 to 6 input points. For example, the number of the secondary feeding connection paths, that is, the number of the second connecting members 200, can be 2, 3, 4, 5, 6, 7, 8 or more. The number and installation positions of the second connecting members 200 can be adjusted according to the actual situation.

In this embodiment, the second connecting member 200 can be used to input radio frequency current. By setting multiple, that is, two or more second connecting members 200, a plurality of feeding connection ports can be formed, that is, there are multiple input points of the feeding structure. For example, it can be 2, 3, 4, 5, 6, etc., and the specific number can be adjusted according to the actual situation, and this embodiment does not specifically limit it. The input point (power feeding point) of the radio frequency feeding structure is the electrical connection area between the second end 220 of the second connecting member and the electrode such as the cathode.

Further, the multiple second connecting members 200 are arranged at intervals. For example, the multiple second connecting members 200 can be arranged at equal intervals or unequal intervals, and the distance between the second connecting members 200 is adjustable. For example, during installation, the first end 210 of the second connecting member is moved freely on the fixing hole 301, so as to adjust the distance of the second connecting members 200 or the positions of the second connecting members 200. In practical applications, the positions of the second connecting members 200 can be adjusted and moved according to the distribution of the film deposition. Thus, the fixing hole 301 of this embodiment extends in the first direction, which can form a distance-adjusting or position-adjusting structure. Furthermore, the positions or distances of the multiple power feeding points of the radio frequency feeding structure can be adjusted. The plasma enhanced chemical vapor deposition apparatus can freely adjust the positions of the power feeding points of the radio frequency feeding structure according to the actual film thickness distribution of the film layer, thus further improving the product yield and being applicable to a wider range of product requirements.

For example, 4 second connecting members 200 can be installed to form a feeding structure with 4 power feeding points and form a 4-point symmetrical structure; or one of the second connecting members 200 can be moved to form a 4-point asymmetrical structure. Or, one of the second connecting members 200 can be removed, that is, 3 second connecting members 200 are installed to form a feeding structure with 3 power feeding points. Or, two of the second connecting members 200 can be removed, that is, 2 second connecting members 200 are installed to form a feeding structure with 2 power feeding points. Or, one more second connecting member 200 can be added, that is, 5 second connecting members 200 are installed to form a feeding structure with 5 power feeding points. Of course, other numbers and positions of feeding points can also be selected.

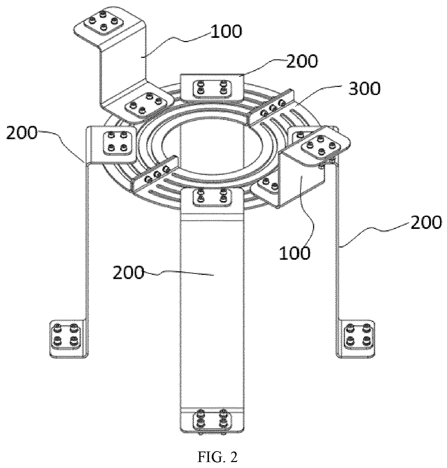

According to the present application, the number of the first connecting members 100 can be one or more. As shown in Figure 1, in this embodiment, one first connecting member 100 can be provided. Or, in other embodiments, as shown in Figure 2, two first connecting members 100 can be provided. The first ends 110 of the two first connecting members are respectively connected to two different sets of radio frequency power supply systems, and the second ends 120 of the two first connecting members are respectively connected to the fixing holes 301.

Thus, two different radio frequency power supply systems can be provided, such as two radio frequency power supply systems with different frequencies and different powers, and a set of matching circuits can be configured for each respectively. The first ends 110 of the two first connecting members are respectively connected to these two different sets of radio frequency power supply systems, which can adapt to different process requirements and expand the application range.

Continuing to refer to Figure 1 or Figure 2, in some embodiments, the radio frequency feeding structure further includes a first fixing component 400 and a second fixing component 500. The first connecting member 100 can be fixed on the fixing plate 300 through the first fixing component 400, and the second connecting member 200 can be fixed on the fixing plate 300 through the second fixing component 500.

Specifically, the first fixing component 400 includes a first fixing plate 410 and a first fastener 420. The first fixing plate 410 is connected to the second end 120 of the first connecting member 100, and the first fastener 420 is inserted through the first fixing plate 410, the second end 120 of the first connecting member 100, and the fixing hole 301 to fix the second end 120 of the first connecting member 100. The second fixing component 500 includes a second fixing plate 510 and a second fastener 520. The second fixing plate 510 is connected to the first end 210 of the second connecting member 200, and the second fastener 520 is inserted through the second fixing plate 510, the first end 210 of the second connecting member 200, and the fixing hole 301 to fix the first end 210 of the second connecting member 200.

Optionally, the first fastener 420 includes but is not limited to screws, bolts, rivets, etc. Optionally, the second fastener 520 includes but is not limited to screws, bolts, rivets, etc.

Optionally, the first end 110 of the first connecting member can also be provided with a first fixing component 400 for connecting with the radio frequency power supply system. Optionally, the second end 220 of the second connecting member can also be provided with a second fixing component 500 for connecting with an electrode such as the cathode.

In this embodiment, during installation, the second end 120 of the first connecting member can be moved on the fixing hole 301 to adjust its position. After the position is determined, the first connecting member 100 can be locked by using the first fixing component 400, so that the first connecting member 100 is in close contact with the fixing plate 300 to ensure the electrical connection effect. For example, the first connecting member 100 is connected to the first fixing plate 410, and the second end 120 of the first connecting member 100 and the first fixing plate 410 are fastened by using the first fastener 420 such as a screw, that is, fixed at the fixing hole 301. It should be understood that the second end 120 of the first connecting member 100 may be provided with a connecting hole, and the first fixing plate 410 is provided with a through-hole corresponding to the connecting hole of the second end 120 of the first connecting member 100. The first fastener 420 such as a screw can pass through the through-hole of the first fixing plate 410 and the connecting hole of the second end 120 of the first connecting member 100 and then be connected to the fixing hole 301 of the fixing plate 300.

Similarly, during installation, the first ends 210 of the multiple second connecting members 200 can be moved on the fixing hole 301 to adjust their positions. After the positions are determined, the second connecting member 200 can be locked by using the second fixing component 500, so that the second connecting member 200 is in close contact with the fixing plate 300 to ensure the electrical connection effect. For example, the second connecting member 200 is connected to the second fixing plate 510, and the first end 210 of the second connecting member 200 and the second fixing plate 510 are fastened by using the second fastener 520 such as a screw, that is, fixed at the fixing hole 301. It should be understood that the first end 210 of the second connecting member 200 may be provided with a connecting hole, and the second fixing plate 510 is provided with a through-hole corresponding to the connecting hole of the first end 210 of the second connecting member 200. The second fastener 520 such as a screw can pass through the through-hole of the second fixing plate 510 and the connecting hole of the first end 210 of the second connecting member 200 and then be connected to the fixing hole 301 of the fixing plate 300.

Through the arrangement of the first fixing component 400 and the second fixing component 500, the first connecting member 100 and the second connecting member 200 can be effectively fixed in a certain position, that is, the first connecting member 100 and the second connecting member 200 are locked, so that the first connecting member 100 and the second connecting member 200 are in close contact with the fixing plate 300 to ensure the electrical connection effect. Moreover, the structure is simple, which is convenient for installation and disassembly, and it is easy to adjust the positions of the first connecting member 100 and the second connecting member 200.

In addition, using the fixing plate and screws for splicing and fixing can be applied to experimental apparatus or mass-production apparatus. Optionally, after the structure is determined, integral casting can be carried out for application in experimental apparatus or mass-production apparatus.

Of course, in other embodiments, the ways of fixing the first connecting member 100 and the second connecting member 200 on the fixing plate 300 are not limited to this, and other connection and fixing methods can also be adopted. For example, the second end 120 of the first connecting member and the first end 210 of the second connecting member 200 can be respectively provided with a protruding part, and a connection such as a mortise-and-tenon connection is formed between the protruding part and the fixing hole 301 of the fixing plate 300 to realize the electrical connection between the first connecting member 100 and the second connecting member 200 and the fixing plate 300.

In some embodiments, the fixing plate 300 is in the shape of a circular ring, an elliptical ring (or a ring-like shape), and the fixing hole 301 is an arc-shaped fixing hole 301. The second end 120 of the first connecting member and the first end 210 of the second connecting member can be adjustably moved along the arc-shaped fixing hole respectively.

In this embodiment, the fixing plate 300 can have various shapes and structures. For example, it can be in the shape of a circular ring, an elliptical ring, a square ring, etc. The specific shape and structure of the fixing plate 300 can be adjusted according to the actual application situation. The circular-ring-shaped fixing plate 300 has a simple structure, is convenient for processing and manufacturing, and has a wide range of applications.

In this embodiment, the size of the entire radio frequency feeding structure can also be adjusted according to the actual working conditions of different apparatus. For example, the size of the fixing plate 300 can be adjusted according to the actual working conditions and requirements. The length, width, thickness, etc. of the first connecting member 100 and the second connecting member 200 can all be adjusted according to the actual working conditions and requirements, which can meet the needs of a wider application range.

For example, when a circular-ring-shaped fixing plate 300 is used, the fixing hole 301 can be designed as an arc-shaped fixing hole, and the extension direction of the fixing hole 301, that is, the first direction mentioned above, can be the circumferential direction of the fixing plate 300. The first connecting member 100 is arranged between two second connecting members 200. The second end 120 of the first connecting member can be adjustably moved along the arc-shaped fixing hole to adjust its position. The first ends 210 of the multiple second connecting members can also be adjustably moved along the arc-shaped fixing hole respectively to adjust their respective positions.

In other embodiments, the fixing plate 300 is in the shape of a square ring, and the fixing hole 301 is a linear fixing hole. The second end 120 of the first connecting member and the first end 210 of the second connecting member can be adjustably moved along the linear fixing hole respectively. When a square-ring-shaped fixing plate 300 is used, the fixing hole 301 can be designed as a linear (such as a straight-line) fixing hole, and the extension direction of the fixing hole 301, that is, the first direction mentioned above, can be the length direction or the width direction of the fixing plate 300. The first connecting member 100 is arranged between two second connecting members 200. The second end 120 of the first connecting member can be adjustably moved along the linear fixing hole to adjust its position. The first ends 210 of the multiple second connecting members can also be adjustably moved along the linear fixing hole respectively to adjust their respective positions.

In some embodiments, the fixing plate 300 includes a first main plate 310 and a second main plate 320. The first main plate 310 and the second main plate 320 are detachably connected together to form the fixing plate 300. Optionally, the number of the fixing holes 301 is multiple, and the multiple fixing holes 301 are arranged at intervals along the second direction. For example, when a circular-ring-shaped fixing plate 300 is used, the second direction can be the radial direction, and multiple fixing holes 301, such as two or more arc-shaped fixing holes, are arranged at intervals along the radial direction of the fixing plate 300. In this embodiment, the number and positions of the fixing holes 301 can be increased according to the actual situation to meet the requirements of a wider range of movement, and it is also beneficial for heat dissipation. for example, two, three or more than three fixing holes 301 can be provided.

The fixing plate 300 mentioned above is formed by the first main plate 310 and the second main plate 320, and the first main plate 310 and the second main plate 320 are in a split structural form. That is, during manufacturing, the first main plate 310 and the second main plate 320 can be manufactured separately. During installation, the first main plate 310 and the second main plate 320 can be assembled together to form the fixing plate 300. In this way, the fixing plate 300 is formed by the detachable connection of the first main plate 310 and the second main plate 320, which is convenient for installation and disassembly, and is easy to maintain.

Optionally, the first main plate 310 is provided with a first protruding connecting portion, and the second main plate 320 is provided with a second protruding connecting portion. The first protruding connecting portion and the second protruding connecting portion are butted, and then fixed by fasteners such as screws to form the entire fixing plate 300.

In this embodiment, the splicing method of the device structure, which uses screws, fixing plates or protruding parts for fixing, can be applied to experimental apparatus or mass-production apparatus. Optionally, after the structure is determined, integral casting can be carried out for application in experimental apparatus or mass-production apparatus. After the device is finalized, or after the positions of the first connecting member and the second connecting member are determined, the integral casting method can be used to further reduce the contact influence at the connection.

In some embodiments, the materials of the first connecting member 100, the second connecting member 200 and the fixing plate 300 each independently include metals or alloys. Among them, the metals include copper, aluminum, gold or silver, and the alloys include copper-aluminum alloy, copper-silver alloy, copper-nickel alloy or copper-tin alloy.

It can be understood that the first connecting member 100, the second connecting member 200 and the fixing plate 300 are made of conductive materials.

In this embodiment, the materials of the radio frequency feeding structure can be metals or alloys. For example, the materials of the first connecting member 100, the second connecting member 200 and the fixing plate 300 can respectively be conductive materials such as metals or alloys. Optionally, the materials of the first fixing component 400 and the second fixing component 500 can also be conductive materials such as metals or alloys.

For example, considering factors such as cost, the power and frequency of the feeding power supply, the first connecting member 100, the second connecting member 200 and the fixing plate 300 can be made of copper metal material, or aluminum metal material can also be selected, and copper is preferably chosen. Of course, other metal materials can also be selected. Or, the first connecting member 100, the second connecting member 200 and the fixing plate 300 can also be made of alloy materials such as copper-aluminum alloy.

In some embodiments, the materials of the first connecting member 100, the second connecting member 200 and the fixing plate 300 each independently include composite materials. The composite materials include a base material and a coating layer disposed on the outer surface of the base material. The base material includes copper or aluminum, and the coating layer includes a gold coating layer or a silver coating layer. Optionally, the materials of the first fixing component 400 and the second fixing component 500 can also be the composite materials mentioned above.

In this embodiment, considering factors such as the cost of the apparatus, the power and frequency of the feeding power supply, and in accordance with the skin effect principle-whereby, at the different frequencies, the higher frequency, the more the current flows on the surface of the metal, the first connecting member 100, the second connecting member 200 and the fixing plate 300 can be made of composite materials with a coating layer on the surface. For example, a copper base material can be selected, and a silver coating layer is formed on the surface of the copper base material, that is, a composite material including a copper base material and a silver coating layer on the surface of the copper base material is used; or a copper base material can be selected, and a gold coating layer is formed on the surface of the copper base material, that is, a composite material including a copper base material and a gold coating layer on the surface of the copper base material is used; or an aluminum base material can be selected, and a silver coating layer is formed on the surface of the aluminum base material, that is, a composite material including an aluminum base material and a silver coating layer on the surface of the aluminum base material is used. Of course, other metal base materials can also be used, and composite materials with metals with good electrical conductivity such as gold and silver coated on the surface of the metal base material can be used.

Thus, by taking advantage of the skin effect, for the materials of the radio frequency feeding structure, the method of plating precious metals such as gold and silver on the surface of metals with lower cost can be adopted. This can increase the electrical conductivity and reduce the power loss while reducing the apparatus cost.

In some embodiments, the first end 110 of the first connecting member is provided with a smooth first chamfered portion, the second end 120 of the first connecting member is provided with a smooth first chamfered portion, and the outer surface of the first connecting member 100 has a polished smooth surface. The first chamfered portion mentioned above is not limited to being provided at the first end 110 and the second end 120 of the first connecting member. Other edges, corners and tip parts of the first connecting member 100 can also be rounded to form a smooth first chamfered portion.

By polishing the surface of the first connecting member 100 to make it smooth and rounding off the edges and corners to form smooth chamfers, point discharge caused by sharp corners and burrs can be prevented.

In some embodiments, the first end 210 of the second connecting member 200 is provided with a smooth second chamfered portion, the second end 220 of the second connecting member 200 is provided with a smooth second chamfered portion, and the outer surface of the second connecting member 200 has a polished smooth surface. The second chamfered portion mentioned above is not limited to being set at the first end 210 and the second end 220 of the second connecting member 200. Other edges, corners and tip parts of the second connecting member 200 can also be rounded to form a smooth second chamfered portion. In addition, other structural parts of the radio frequency feeding structure, such as the fixing plate 300, the first fixing component 400, and the second fixing component 500, also need to be polished to make the surface smooth and rounded.

By polishing the surface of the second connecting member 200 and other structures to make them smooth and rounding off the edges and corners to form smooth chamfers, point discharge caused by sharp corners and burrs can be prevented.

In some embodiments, the first connecting member 100 has a Z-shaped or Z-like structure; the second connecting member 200 has a Z-shaped or Z-like structure. The shape and structure of the first connecting member 100 and the second connecting member 200 can be the same or different.

The two parallel parts of the Z-shaped or Z-like first connecting member 100, which are arranged opposite to each other at both ends, can be respectively used as the first end 110 and the second end 120 of the first connecting member 100. Similarly, the two parallel parts of the Z-shaped or Z-like second connecting member 200, which are arranged opposite to each other at both ends, can be respectively used as the first end 210 and the second end 220 of the second connecting member 200.

In some embodiments, the power range of the radio frequency power supply that the radio frequency feeding structure can pass through is 50W to 20kW. For example, the power of the radio frequency power supply can be 500W to 5000W; or the power of the radio frequency power supply can be 1000W to 10000W; or the power of the radio frequency power supply can be 5000W to 20000W; or the power of the radio frequency power supply can be 100W, 500W, 2000W, 5000W, 10000W, 15000W, 20000W, etc., and other radio frequency power levels can also be used.

In some embodiments, the frequency range of the radio frequency power supply that the radio frequency feeding structure can pass through is 0.3MHz to 100MHz. For example, the frequency range of the radio frequency power supply is 2 MHz to 30MHz. Or the frequency range of the radio frequency power supply is 20 MHz to 60MHz; or the frequency range of the radio frequency power supply is 50 MHz to 100MHz; or the frequency of the radio frequency power supply can be 0.4MHz, 2MHz, 10MHz, 13.56MHz, 20MHz, 25.2MHz, 27.12MHz, 30.5MHz, 40.68MHz, 60MHz, 75MHz, 80MHz, 100MHz, etc., and other frequencies can also be used.

In conclusion, for the radio frequency feeding structure of this embodiment, the positions and the number of the power feeding points can be freely adjusted according to the actual working conditions and experimental results. The installation is convenient and fast, which is helpful for summarizing regularities, developing and optimizing apparatus. The multi-point feeding mode helps to improve the uniformity of radio frequency film deposition and increase the deposition rate. Combined with the skin effect, the materials of each structure are plated with gold, silver, etc. on the surface, which helps to reduce the apparatus material cost and the feeding power loss.

In some embodiments, a PECVD apparatus is also provided, and the PECVD apparatus includes the aforementioned radio frequency feeding structure. The PECVD apparatus can be used for film deposition on the surface of a substrate.

It should be understood that the remaining structural parts, connection settings, etc. in the PECVD apparatus can refer to the existing technologies, which are not limited here and will not be elaborated further.

The parts not described in detail in the present utility model are well-known technologies to those skilled in the art.

The embodiments of the present application have been described above in conjunction with the accompanying drawings. However, the present application is not limited to the above specific implementation manners. The above specific implementation manners are merely illustrative rather than restrictive. Under the inspiration of the present application, those of ordinary skill in the art can also make many forms without departing from the purpose of the present application and the scope protected by the claims, and all of them belong to the protection scope of the present application.

## Claims

1. A radio frequency feeding structure for a PECVD apparatus, **characterized in that** the radio frequency feeding structure comprises:
at least one first connecting member, the first end of the first connecting member is connected to a radio frequency power supply system;
a fixing plate, which is provided with a fixing hole, the fixing hole extends in a first direction, and the second end of the first connecting member is connected to the fixing hole;
a plurality of second connecting members, the first end of each second connecting member is connected to the fixing hole, and the first end of the second connecting members is adapted to move along the fixing hole in the first direction, the second end of the second connecting member is used for electrical connection with an electrode in the reaction chamber of the PECVD apparatus.

2. The radio frequency feeding structure according to claim 1, further comprising a first fixing component and a second fixing component;
wherein, the first fixing component comprises a first fixing plate and a first fastener, the first fixing plate is connected to the second end of the first connecting member, and the first fastener is inserted through the first fixing plate, the second end of the first connecting member and the fixing hole to fix the second end of the first connecting member;
the second fixing component comprises a second fixing plate and a second fastener, the second fixing plate is connected to the first end of the second connecting member, and the second fastener is inserted through the second fixing plate, the first end of the second connecting member and the fixing hole to fix the first end of the second connecting member.

3. The radio frequency feeding structure according to claim 1, wherein the number of the second connecting members is 2 to 10, so that the radio frequency feeding structure forms a feeding structure with 2 to 10 input points.

4. The radio frequency feeding structure according to claim 3, wherein he number of the second connecting members is 4 to 8, so that the radio frequency feeding structure forms a feeding structure with 4 to 8 input points.

5. The radio frequency feeding structure according to claim 1, wherein a plurality of the second connecting members are arranged at intervals, and the distance between the second connecting members is adjustable.

6. The radio frequency feeding structure according to claim 1, wherein the fixing plate is in the shape of a circular ring or an elliptical ring, the fixing hole is an arc-shaped fixing hole, and the second end of the first connecting member and the first end of the second connecting member are respectively adjustable and movable along the arc-shaped fixing hole.

7. The radio frequency feeding structure according to claim 1, wherein the fixing plate is in the shape of a square ring, the fixing hole is a linear fixing hole, and the second end of the first connecting member and the first end of the second connecting member are respectively adjustable and movable along the linear fixing hole.

8. The radio frequency feeding structure according to claim 1, wherein the fixing plate comprises a first main plate and a second main plate, the first main plate and the second main plate are detachably connected together to form the fixing plate.

9. The radio frequency feeding structure according to claim 8, wherein the first main plate is provided with a first protruding connecting portion, and the second main plate is provided with a second protruding connecting portion, the first protruding connecting portion is butted against the second protruding connecting portion, and fasteners are used to connect the first protruding connecting portion and the second protruding connecting portion together tightly.

10. The radio frequency feeding structure according to claim 1, wherein the number of the fixing holes is multiple, and the multiple fixing holes are arranged at intervals along the second direction.

11. The radio frequency feeding structure according to claim 1, wherein the materials of the first connecting member, the second connecting member and the fixing plate each independently include metals or alloys, the metals include copper, aluminum, gold or silver, and the alloys include copper-aluminum alloy, copper-silver alloy, copper-nickel alloy or copper-tin alloy;
or, wherein the materials of the first connecting member, the second connecting member and the fixing plate each independently include composite materials, the composite materials include a base material and a coating layer disposed on the outer surface of the base material, the base material includes copper or aluminum, and the coating layer includes a gold coating layer or a silver coating layer.

12. The radio frequency feeding structure according to claim 1, wherein the number of the first connecting members is two, the first ends of the two first connecting members are respectively connected to two different radio frequency power supply systems, and the second ends of the two first connecting members are respectively connected to the fixing holes.

13. The radio frequency feeding structure according to any one of claims 1 to 12, wherein both the first end and the second end of the first connecting member are provided with smooth first chamfered portions, and the outer surface of the first connecting member has a polished smooth surface.

14. The radio frequency feeding structure according to any one of claims 1 to 12, wherein both the first end and the second end of the second connecting member are provided with smooth second chamfered portions, and the outer surface of the second connecting member has a polished smooth surface.

15. The radio frequency feeding structure according to any one of claims 1 to 12, wherein the first connecting member is in the shape of a Z; and the second connecting member is in the shape of a Z.

16. A PECVD apparatus, which comprising the radio frequency feeding structure according to any one of claims 1 to 15 .
